# EUROPÄISCHE PATENTANMELDUNG

(11) **EP 0 983 804 A1**
(43) Veröffentlichungstag der Anmeldung: **08.03.2000**
(21) Anmeldenummer: 99114291.0
(22) Anmeldetag: 29.07.1999
(51) Int. Cl.: B07C 5/10, C30B 15/02

(54) **Klassiervorrichtung**

(30) Priorität: 03.09.1998 DE 19840200
(71) Anmelder: Wacker-Chemie GmbH, 81737 München (DE)
(72) Erfinder: Flottmann, Dirk, Dr., 84503 Altötting (DE); Hesse, Karl, Dr., 84489 Burghausen (DE); Schantz, Matthäus, 84367 Reut (DE)
(74) Vertreter: Fritz, Helmut, Dr.

(57) **Zusammenfassung**

Vorrichtung zum optoelektronischen Klassieren von Halbleitermaterialien, die dadurch gekennzeichnet ist, daß sie eine Erkennungsvorrichtung 6, die die Morphologie des Klassierguts 1 an eine Auswertungsvorrichtung 7 weiterleitet, die die Daten auswertet, aufweist.

## Beschreibung

Die Erfindung betrifft eine Vorrichtung und ein Verfahren zum optoelektronischen Klassieren von Halbleitermaterialien.

Um zum Beispiel aus polykristallinen Stäben monokristalline Stäbe herzustellen, werden die polykristallinen Stäbe in Bruchstücke zu etwa 100 mm Durchmesser zerkleinert. Diese Bruchstücke werden zum Befüllen eines Tiegels beim Czochralski-Kristallziehen (CZ-Krstallziehen) verwendet. Da die Oberfläche der Stäbe an verschiedenen Stellen unterschiedlich rauh ist, gibt es somit nach dem Brechen Bruchstücke, die diese rauhen Oberflächenanteile besitzen. Zur Zeit werden die Teile z.B. mit Rissen, Erhebungen (Popkorn), Kratern (verbale Klassifizierung) etc. von geschultem Personal händisch aussortiert, bevor sie in den Tiegel zum CZ-Kristallziehen gelangen, weil dort dieses Defektmaterial zu Qualitätseinbußen im Prozeß führt.

Aufgabe der Erfindung ist es eine Vorrichtung und ein Verfahren zu entwickeln, daß ohne den Einsatz von subjektivem Personal die Defekte aussortiert.

Die Aufgabe wird durch die Erfindung gelöst.

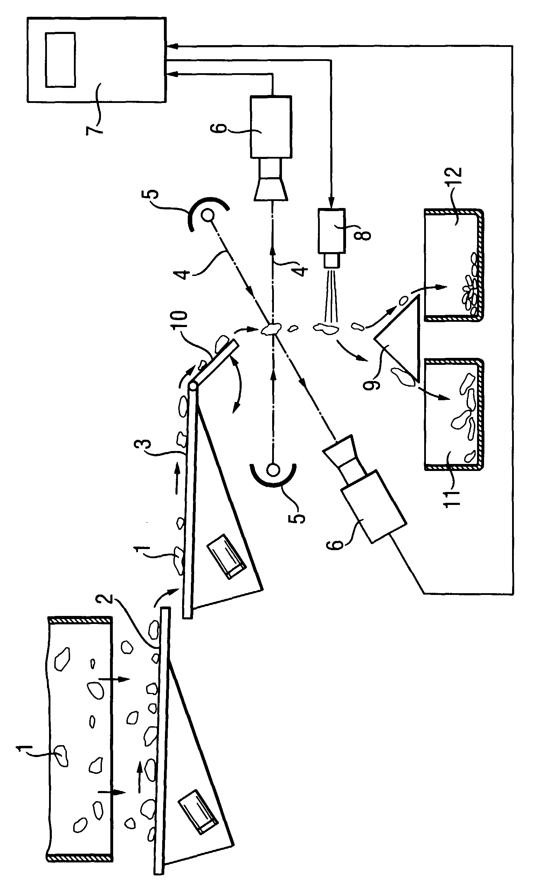

Die Figur zeigt eine erfindungsgemäße Vorrichtung.

Gegenstand der Erfindung ist eine Vorrichtung zum optoelektronischen Klassieren von Halbleitermaterialien, dadurch gekennzeichnet, daß sie eine Erkennungsvorrichtung 6, die die Morphologie des Klassierguts 1 an eine Auswertungsvorrichtung 7 weiterleitet, die die Daten auswertet, aufweist.

Die Vorrichtung wird vorzugsweise dazu genutzt, sprödharte Halbleitermaterialien, wie Silicium, Germanium oder Galliumarsenid nach der Morphologie zu klassieren. Bevorzugt wird Silicium damit klassiert. Mit dieser Vorrichtung kann Halbleitermaterial nach der Morphologie getrennt werden.

Die Vorrichtung ist so aufgebaut, daß das zu klassierende Gut 1 vorzugsweise zuerst auf eine Vorrichtung 2 zum Vereinzeln und vorzugsweise zum gleichzeitigen Fördern kommt, die bevorzugt eine Schwingfördereinrichtung ist. Diese Schwingfördereinrichtung wird vorzugsweise in Schwingungen versetzt, durch die der Bruch aus Halbleitermaterial vereinzelt wird und vorzugsweise zum Zuführer 3 in Richtung der Gleitfläche 10 transportiert wird. Es ist jedoch auch möglich, das Material schon vereinzelt auf eine Fördervorrichtung zu legen. Der Winkel dieser Gleitfäche 10 ist vorzugsweise zur Horizontalen verstellbar; er wird in Abhängigkeit vom Reibungskoeffizienten zwischen Bruchstück und Oberflächenbelag so eingestellt, daß die Bruchstücke vorzugsweise unter Wirkung der Schwerkraft nach unten gleiten. Der Winkel wird in einem Bereich von 20° bis 80° vorzugsweise 30° bis 70° eingestellt. Die Vorrichtung 2 zum Vereinzeln, und vorzugsweise zum Fördern, der Zuführer 3 und die Gleitfläche 10 sind so aufgebaut, daß an ihren Oberflächen das zu klassierende Halbleitermaterial 1 nicht mit anderen Materialien als dem zu klassierenden Halbleitermaterial in Berührung kommt. Dies geschieht vorzugsweise durch eine Beschichtung dieser Vorrichtung 2 zum Vereinzeln und vorzugsweise zum Fördern, des Zuführers 3 und der Gleitfläche 10 mit demselben Halbleitermaterial wie das, das klassiert werden soll. Die Vorrichtung 2 zum Vereinzeln, der Zuführer 3 und die Gleitfläche 10 können auch vollständig aus dem entsprechenden Halbleitermaterial aufgebaut sein. Im Falle von Silicium, also mit Silicium beschichtet sein oder aus Silicium bestehen. Auf der Gleitfläche richten sich die Teilchen derart aus, daß ihr Schwerpunkt möglichst niedrig zu liegen kommt. Das bedeutet, daß die Halbleiterbruchstücke bei ihrem freien Fall nach Passieren der Gleitfläche 10 der Strahlenquelle 5 die größte Projektionsfläche zuwenden und sie werden von zumindest einer Strahlenquelle 5 erfaßt. Die Fallhöhe zwischen der Gleitfläche 10 und der Ablenkvorrichtung 8 beträgt vorzugsweise 5 cm bis 20 cm, bevorzugt 10 cm. In ungefähr der Mitte dieser Fallstrecke sind eine Strahlenquelle 5 und eine Formerfassungsvorrichtung 6 angeordnet, wobei sich das Teilchen zwischen der Strahlenquelle 5 und der Formerfassungsvorrichtung 6 bewegt. Der Abstand des Teilchens zur Strahlenquelle 5 beträgt vorzugsweise 50 cm bis 120 cm, besonders bevorzugt 70 cm und des Teilchens zur Formerfassungsvorrichtung 6 beträgt vorzugsweise 5 cm bis 12 cm, besonders bevorzugt 6 cm. Bei der Strahlenquelle 5 handelt es sich vorzugsweise um eine elektromagnetische Strahlenquelle, wie einen Laser oder eine Lampe, die sichtbares Licht im Bereich von 400 nm bis 700 nm ausstrahlt.

Bei der Erkennungsvorrichtung 6 handelt es sich vorzugsweise um zumindest einen hochauflösenden Sensor, der ein diskreter Halbleitersensor oder CCD Zeilensensor sein kann, die in einer oder mehreren Kameras sich befinden können, zur Erfassung von sichtbaren Licht, das als Reflexionslicht von der Oberfläche der Bruchstücke reflektiert wird. Dieser Sensor ist mit einer Auswertungsvorrichtung 7 verbunden, die die eingehenden Daten auswertet und automatisch in ein Binärbild umwandelt. Bei dieser Auswertungsvorrichtung 7 handelt es sich vorzugsweise um einen Rechner.

Eine numerische Methode zur Auswertung der Wellenanteile, die durch die Wechselwirkung Popkorn mit Licht entstehen, in Datenreihen ist die diskrete Fouriertransformation. Diese liefert eine nach Frequenzen aufsteigende Datenreihe.

Diese Auswertungsvorrichtung 7 steuert nach einem vorgegebenen Programm zumindest eine Ablenkvorrichtung 8. Dabei kann dieses Erfassungssystem aus Auswertungsvorrichtung 7 und Erkennungsvorrichtung 6 eine bestimmte Morphologie wie Krater, Hügel, Risse oder "Popkorn" vorzugsweise mittels Fuzzylogik erkennen. Mit welcher Intensität und bis zur welchen Auflösung Löcher, Hügel und Furchen im Binärbild abgebildet werden, kann an der Auswertungsvorrichtung 7 festgelegt werden. Mit der Ablenkvorrichtung 8 kann ein Bruchstück ausgeschleust werden, wobei die Anzahl und Tiefe des morphologischen nicht in die Spezifikation passenden Materials bestimmt, ob es ausgeschleust wird. Bei der Ablenkvorrichtung 8 handelt es sich vorzugsweise um eine Düse, aus der vorzugsweise Gase oder Flüssigkeiten ausgestoßen werden, wobei es sich bei den Gasen vorzugsweise um Luft oder auch um inerte Gase, wie Stickstoff handelt, die mit einem Druck oberhalb des Normaldrucks, vorzugsweise mit 3 bis 10 bar, besonders bevorzugt mit 6 bar ausgestoßen werden. Bei den Flüssigkeiten wird vorzugsweise hochreines Wasser, mit einem Leitwert von vorzugsweise unter 0.14 µS, besonders bevorzugt von 0,08 µS mit einem Druck von vorzugsweise 2 bis 20 bar ausgestoßen. In einer besonderen Ausführung wird ein zu großes Teilchen mit einem Wasserstrahl von vorzugsweise 1500 bar bis 5000 bar, besonders bevorzugt von 3500 bar beaufschlagt und dabei zerkleinert. Die Ablenkvorrichtung 8 kann allein angeordnet sein oder aus mehreren nebeneinander angeordneten Düsen bestehen, die vorzugsweise in einer Reihe in einem Abstand von vorzugsweise 3 bis 15 mm, besonders bevorzugt von 9 mm angeordnet sind, wenn die Teilchen parallel durch den Strahlengang der Strahlenquelle 5 fallen. Die abgelenkten Teilchen mit der gewünschten Morphologie werden vorzugsweise über eine Trennvorrichtung 9 in einem Auffangbehälter 11 gesammelt und die nicht abgelenkten Teilchen werden in einem Auffangbehälter 12 gesammelt. Die Auffangbehälter können zumindest in ihrem Inneren eine Oberfläche aus dem zu klassierenden Halbleitermaterial aufweisen oder aus diesem bestehen. Die beiden aufgefächerten Gutströme können durch weitere Erfassungssysteme und Ablenkvorrichtungen in weitere Klassen aufgeteilt werden. Es wäre auch möglich, durch die Anordnung von weiteren Trennvorrichtungen eine Gutsauftrennung in mehrere Klassen zu erreichen, wobei die Auffächerung der Flugbahn mit verschieden starken Ablenkeinwirkungen, vorzugsweise mit verschieden starken Luftstößen erfolgt. Diese Trennvorrichtung ist auf der Oberfläche vorzugsweise mit dem zu klassierenden Halbleitermaterial versehen oder besteht aus diesem.

Ein weiterer Gegenstand ist ein Verfahren zum optoelektronischen Klassieren von Halbleitermaterialien, wobei das Klassiergut mit einer Erkennungseinheit 6, die seine Morphologie erkennt, erfaßt wird und diese an eine Auswertungsvorrichtung 7 weitergibt.

Bei dem bevorzugten erfindungsgemäßen Verfahren wird das zerkleinerte Gut 1, in diesem Fall Halbleitermaterial, in eine Vorrichtung 2 zum Vereinzeln 2 und zum Zuführer 3 auf eine Gleitfläche 10 befördert, deren Winkel vorzugsweise in Abhängigkeit vom Reibungskoeffizienten zwischen zu klassierenden Halbleitermaterial und Oberflächenbelag so eingestellt wird, daß das zu klassierende Halbleitermaterial vorzugsweise unter Wirkung der Schwerkraft nach unten gleitet. Dabei erfolgt eine Ausrichtung des unregelmäßig geformten Halbleitermaterials in der Art, daß sein Schwerpunkt möglichst niedrig zu liegen kommt, das bedeutet, daß es seine größte Projektionsfläche der Gleitfläche 10 zuwendet. In dieser Ausrichtung passiert das zerkleinerte Gut nach Verlassen der Gleitfläche 10 das Erfassungssystem, das aus Strahlenquelle 5 und Erkennungsvorrichtung 6 besteht, den Strahlengang 4 der Strahlenquelle 5, das auftretende Reflexionslicht der Oberfläche wird in Echtzeit vermessen und klassifiziert und wird dabei von einer Erkennungsvorrichtung 6 erfaßt, die vorzugsweise eine optische Auflösung von 0,1 mm bis 20 mm und besonders bevorzugt eine optische Auflösung von 0,5 mm bis 10 mm hat. Aus der Auslenkung der Lichtstrahlen werden die verschiedenen Höhen und Neigungswinkel der Flächen berechnet. die entstehenden Oberflächenbilder werden einer Gesamtanalyse z.B. unter Verwendung von verschiedenen Filtertechniken unterzogen, so daß vom Echtzeitbild ein Binärbild entsteht. Die entstehenden dunklen Zonen auf dem Binärbild vom Polysiliciumbruchstück werden automatisch hinsichtlich ihrer Morphologie und Anzahl an Defektstellen untersucht. Weitere in Frage kommende optische Verfahren zur Oberflächeninspektion sind das Triangulations-/bzw. Lichtschnittverfahren oder die Graubildanalyse. Beim ersteren wird einen Linienfächer beim letzteren einzelne Lichtpunkte aus elektromagnetischer Strahlung auf die Bruchstücke gerichtet und dort fokussiert. Der entstehende Profilschnitt wird mit einem Matrix-Kamera-System detektiert. Die noch meßbaren Höhenunterschiede des Meßobjektes werden durch den Betrachtungswinkel und die Auflösung der CCD-Sensors bestimmt.

Bei der Graubildanalyse wird das Meßobjekt nicht strukturiert (projiziertes Linienmuster), sondern gerichtet beleuchtet, um anhand der Schattenbildung am Objekt die Popkornstruktur zu erkennen. Die Ortsauflösung, welche für die Detektion notwendig ist liegen bei diesen Verfahren im Mikrometer bis Millimeterbereich.

Die bisher verbalen unscharfen Ausdrücke können dann vorzugsweise in der Weise einer fuzzy-theoretischen Betrachtung unterzogen werden, daß linguistische Begriffe wie Krater, "Popkorn", Risse etc. durch Zugehörigkeitsfunktionen mit Modifikatoren dargestellt werden. Anzahl der auszuschleusenden Fehlteile sind variabel und der Grad der Ausschleusung ist einstellbar. Nichtsdestotrotz kann eine Ausschleusung schon bei einem Oberflächendefekt erfolgen, wofür keine Fuzzy-Auswertung erfolgen muß. Sobald nach der Binärmorphologieanalyse "Popkorn" oder ähnliche Defekte erkannt und ausgewertet wurden, wird dieses Bruchstück mit vorzugsweise einem Luftimpuls ausgeschleust. Diese gewonnenen Daten werden von einer Auswertungsvorrichtung 7 ausgewertet. Das zu klassierende Halbleitermaterial passiert das Erfassungsystem mit einer Falldauer von 0,05 sec bis 1 sec, besonders bevorzugt von 0,1 sec bis 0,2 sec. Je nach Abweichung der bestimmten Morphologie des zu klassierenden Halbleitermaterials gegenüber dem eingestellten Trennkriterium wird zumindest eine Ablenkvorrichtung 8 angesteuert, die zum Beispiel alle Halbleitermaterial-Teilchen mit Popkorn mit zum Beispiel einem Luftstrahl ablenkt und damit eine Abweichung von der ursprünglichen Flugbahn bewirkt. Eine Trennvorrichtung 9 trennt die beiden Fraktionen, die in getrennten Auffangbehältern 11, 12 gesammelt werden.

Das erfindungsgemäße Verfahren in Verbindung mit der erfindungsgemäßen Vorrichtung hat die Vorteile, daß kontaminationsfrei ohne die subjektive Betrachtungsweise von Personal klassiert werden kann.

## Patentansprüche

1. Vorrichtung zum optoelektronischen Klassieren von Halbleitermaterialien, dadurch gekennzeichnet, daß sie eine Erkennungsvorrichtung 6, die die Morphologie des Klassierguts 1 an eine Auswertungsvorrichtung 7 weiterleitet, die die Daten auswertet, aufweist.

2. Vorrichtung zum optoelektronischen Klassieren von Halbleitermaterialien nach Anspruch 1, dadurch gekennzeichnet, daß die Auswertungsvorrichtung 7, die Daten mittels Fuzzylogik auswertet.

3. Vorrichtung nach Anspruch 1, dadurch gekennzeichnet, daß die Vorrichtung eine Vorrichtung 2 zum Vereinzeln und eine Gleitfläche 10 aufweist, wobei jeweils die Vorrichtung zum Vereinzeln 2 und die Gleitfläche 10 eine Oberfläche aus dem zu klassierenden Halbleitermaterial aufweisen sowie eine Strahlenquelle 5 durch deren Strahlengang 4 das zu klassierende Material 1 fällt.

4. Vorrichtung nach Anspruch 1, dadurch gekennzeichnet, daß die Auswertungsvorrichtung 7 zumindest eine Ablenkvorrichtung 8 ansteuert.

5. Verfahren zum optoelektronischen Klassieren von Halbleitermaterialien, dadurch gekennzeichnet, daß das Klassiergut 1 mit einer Erkennungsvorrichtung 6, die seine Morphologie erkennt, erfaßt wird und diese an eine Auswertungsvorrichtung 7 weitergibt.

6. Verfahren zum optoelektronischen Klassieren von Halbleitermaterialien nach Anspruch 5, dadurch gekennzeichnet, daß die Daten mittels Fuzzylogik ausgewertet werden.

7. Verfahren zum optoelektronischen Klassieren von Halbleitermaterialien nach Anspruch 5 oder 6, dadurch gekennzeichnet, daß das Material von diffusem Licht angestrahlt wird und die Erkennungseinheit ein CCD Zeilensensor ist.

8. Verfahren zum optoelektronischen Klassieren von Halbleitermaterialien nach einem oder mehreren der Ansprüche 5 bis 7, dadurch gekennzeichnet, daß als optisches Verfahren zur Oberflächeninspektion das Triangulationsverfahren verwendet wird.

9. Verfahren zum optoelektronischen Klassieren von Halbleitermaterialien nach einem oder mehreren der Ansprüche 5 bis 7, dadurch gekennzeichnet, daß als optisches Verfahren zur Oberflächeninspektion das Lichtschnittverfahren verwendet wird.

10. Verfahren zum optoelektronischen Klassieren von Halbleitermaterialien nach einem oder mehreren der Ansprüche 5 bis 9, dadurch gekennzeichnet, daß als optisches Verfahren zur Oberflächeninspektion die Graubildanalyse verwendet wird.
